# EUROPÄISCHE PATENTSCHRIFT

(11) **EP 4 038 844 B1**
(45) Veröffentlichungstag und Bekanntmachung des Hinweises auf die Patenterteilung: **08.04.2026**
(21) Anmeldenummer: 20780208.3
(22) Anmeldetag: 30.09.2020
(51) Int. Cl.: H04L 12/40, G05B 19/042, G05B 19/05, H05K 7/14

(54) **EIN/AUSGABE-STATION FÜR EIN FELDBUSSYSTEM, FELDBUS-KOPPLER FÜR DIE EIN/AUSGABE-STATION, SOWIE PLATZHALTERMODUL FÜR DIE EIN/AUSGABE-STATION**
INPUT/OUTPUT STATION FOR A FIELD BUS SYSTEM, FIELD BUS COUPLER FOR THE INPUT/OUTPUT STATION, AND PLACEHOLDER MODULE FOR THE INPUT/OUTPUT STATION
STATION D'ENTRÉE/SORTIE POUR UN SYSTÈME DE BUS DE TERRAIN, COUPLEUR DE BUS DE TERRAIN POUR LA STATION D'ENTRÉE/SORTIE ET MODULE D'ESPACE RÉSERVÉ POUR LA STATION D'ENTRÉE/SORTIE

(30) Priorität: 02.10.2019 LU 101427
(43) Veröffentlichungstag der Anmeldung: 10.08.2022
(73) Patentinhaber: PHOENIX CONTACT GMBH & CO. KG, 32825 Blomberg (DE)
(72) Erfinder: BRAND, Klaus, 32108 Bad Salzuflen Nordrhein-Westfalen (DE); POLLMANN, Jan, 32839 Steinheim Nordrhein-Westfalen (DE); MÜLLER, Frank, 32760 Detmold Nordrhein-Westfalen (DE); MATTHIES, Thorsten, 32683 Barntrup Nordrhein-Westfalen (DE); POLLERT, Stefan, 32339 Espelkamp Nordrhein-Westfalen (DE)
(74) Vertreter: LifeTech IP Spies & Behrndt Patentanwälte PartG mbB
(86) Internationale Anmeldenummer: PCT/EP2020/077337
(87) Internationale Veröffentlichungsnummer: WO 2021/064004

(56) Entgegenhaltungen:
- EP-A1- 2 042 952
- WO-A1-2015/036567
- WO-A2-2007/149688

## Beschreibung

Die vorliegende Erfindung betrifft eine Ein/Ausgabe-Station für ein Feldbussystem, die beispielsweise zur Erfassung von Daten und zur Steuerung von Maschinen und Anlagen verwendbar ist, sowie einen entsprechend ausgelegten Feldbus-Koppler und ein entsprechendes Platzhaltermodul für die Ein/Ausgabe-Station.

Kommunikationssysteme dieser Art, wie beispielsweise Eingabe/Ausgabe (I/O)-Stationen, werden häufig in Produktionsanlagen verwendet, da durch ihren modularen Aufbau vielfältige Anwendungen im Produktionsprozess möglich sind. Ein Kommunikationssystem dieser Art weist insbesondere einen Prozessor, einen Konfigurationsspeicher, ein oder mehrere steckbare Eingabe- und/oder Ausgabe-Module (E/A-Module) und ein internes Bussystem auf. Das oder die E/A-Module bilden hierbei eine Schnittstelle, über die Prozessdaten und Steuerdaten, wie Sensorsignale und Aktorsignale, an zu kontrollierende Geräte gesendet und von diesen empfangen werden können. Das Bussystem umfasst beispielsweise einen Systembus mit einem Datenbus sowie einem Memory-Adressbus für einen Prozess-Datenaustausch zwischen dem Prozessor und dem E/A-Modul, einen Steuerbus sowie einen auch als Peripherieauswahlbus bezeichneten Adressbus. Jedes E/A-Modul weist eine eindeutige Adresse auf, durch die es über den Adressbus angewählt werden kann. Ein Kommunikationssystem dieser Art ist beispielsweise aus der EP 0 952 523 A1 bekannt.

In einer weiteren Ausführungsform enthält das Kommunikationssystem einen Buskoppler und ein internes Bussystem mit integrierten Busteilnehmern, wie in der EP 2 274 655 A1 beschrieben. Die Busteilnehmer sind insbesondere E/A-Module.

I/O-Stationen können in verschiedenen Ausprägungen aufgebaut sein. Bei diesen handelt es sich zum einen um einen Stationsvollausbau, das heißt um eine größte Stationsausprägung, bei der alle Steckplätze einer I/O-Station mit funktionsbefähigten E/A-Modulen bestückt sind, und zum anderen um Varianten der I/O-Station, in denen eines oder mehrere der funktionsbefähigten E/A-Module nicht verbaut sind und Steckplätze der I/O-Station daher leer sind. Die Reihenfolge und der jeweilige Typ der gesteckten E/A-Module ist in den verschiedenen Ausprägungen identisch.

Für diese verschiedenen Ausprägungen einer I/O-Station müssen nach dem Stand der Technik pro Stationsausprägung jeweils ein Projekt oder ein Teilprojekt im Projektierungs- bzw. Engineering-Programm angelegt werden, damit die Soll-Konfiguration der I/O-Station mit der Ist-Konfiguration übereinstimmt. Bei einer Erweiterung der I/O-Station mit einem weiteren oder mehreren E/A-Modulen wird dann das Projektierungsprogramm um ein weiteres Projekt mit der entsprechenden Funktionalität ergänzt.

Dies bedeutet einen erheblichen Aufwand bei einer bereits in einem produzierenden Anlagenteil bzw. einer Maschine installierten I/O-Station, was zu langen Stillstandszeiten führen kann. Weiterhin birgt die Erweiterung eines Systems technische Risiken, da sich Signallaufzeiten verändern können durch die Erweiterung. Die Folge sind hohe Kosten bei der Umrüstung zusammen mit einem schwer kalkulierbaren technischen Risiko.

Aus der EP 2 042 952 A1 ist ein als Schaltgerätesteuerung bezeichnetes Kommunikationssystem dieser Art bekannt, das einen Prozessor, einen Speicher für aktuelle Konfigurationen und mindestens eine Schaltgerätekommunikationsschnittstelle aufweist. Die Schaltgerätesteuerung ist hierbei befähigt, eine Peripherieadresse als nicht bestückt zu identifizieren und in den Speicher für aktuelle Konfigurationen zu speichern, wobei die Adresse für ein nicht bestücktes Gerät reserviert wird. Um einen leeren Steckplatz zu vermeiden, kann hierbei ein physikalisches Platzhaltermodul eingesetzt werden, das anstelle eines funktionsbefähigten E/A-Moduls den Steckplatz besetzt und dem die Adresse des nicht verwendeten E/A-Moduls zugeordnet wird.

Aus der WO 2007/121968 A2 ist ein Steckmodul für eine Kommunikationsschnittstelle im Feldbusbereich bekannt, die eine Funktion einer Speicherprogrammierbaren Steuerung (SPS) beinhaltet. Die Kommunikationsschnittstelle weist eine interne Steuerungsfunktion auf, die auf Kommunikationsdaten so einwirkt, als wäre die Steuerungsfunktion in einem anderen Gerät realisiert.

Dokument WO 2007/149688 A2 bezieht sich auf die Konfiguration von modularen verteilten Eingabe-/Ausgabe-Systemen (E/A-Systemen). Das beschriebene E/A-System ermöglicht es dem Benutzer, eine konsistente E/A-Bilddarstellung in einem verteilten E/A-Netzwerk für verschiedene physische verteilte E/A-Konfigurationen beizubehalten, bei denen ein oder mehrere E/A-Module physisch aus dem System entfernt sind.

Es ist eine Aufgabe der Erfindung, den Projektierungsaufwand für ein Kommunikationssystem der eingangs genannten Art zu reduzieren.

Diese Aufgabe wird durch eine Ein/Ausgabe-Station für ein Feldbussystem gemäß Anspruch 1, einen Feldbus-Koppler für eine Ein/Ausgabe-Station gemäß Anspruch 10 und ein Platzhaltermodul für eine Ein/Ausgabe-Station gemäß Anspruch 11 gelöst.

Die abhängigen Ansprüche beinhalten vorteilhafte Weiterbildungen und Verbesserungen der Erfindung entsprechend der nachfolgenden Beschreibung dieser Maßnahmen.

In einer Ausprägung betrifft die Erfindung eine Ein/Ausgabe-Station für ein Feldbussystem mit einem Feldbus-Koppler, der eine Systembus-Schnittstelle, und eine Feldbus-Schnittstelle mit einer entsprechenden Firmware aufweist, wobei die Ein/Ausgabe-Station eine Anzahl Steckplätze für steckbare Ein/Ausgabe-Module aufweist, in die neben einer Anzahl von Ein/Ausgabe-Modulen wenigstens ein Platzhaltermodul gesteckt ist. Eine Besonderheit besteht darin, dass der Feldbus-Koppler eine Firmware beinhaltet, die für einen Vollausbau der Ein/Ausgabe-Station ausgelegt ist, wobei die Firmware für die Kommunikation mit einer Steuerungs-Station so ausgelegt ist, dass sie von der Steuerungs-Station als projektierte Soll-Konfiguration den Vollausbau der Ein/Ausgabe-Station empfängt, und dass die Firmware in einer Betriebsart unabhängig von der tatsächlich vorliegenden Belegung der Ein/Ausgabe-Station mit Ein/Ausgabe-Modulen der Steuerungs-Station den Vollausbau der Ein/Ausgabe-Station bestätigt. Diese Lösung hat den Vorteil, dass für die verschiedenen Ausprägungen einer Ein/Ausgabe-Station dann nicht mehr pro Stationsausprägung jeweils ein separates Projekt (also mehr als ein Projekt) in der Projektierungs- bzw. Engineering-Software angelegt werden müssen, damit die Soll-Konfiguration der Ein/Ausgabe-Station mit der Ist-Konfiguration übereinstimmt. Es wird damit erreicht, dass für die verschiedenen Ausprägungen einer Ein/Ausgabe-Station nur ein Projekt in der Projektierungs- bzw. Engineering-Software angelegt werden muss, um somit den Projektierungs- und Verwaltungsaufwand für den Kunden, d.h. den Maschinen- oder Anlagenbauer zu reduzieren.

Auch für das Steuerungsprogramm ergeben sich Vorteile. Dabei kann eine optionale Erweiterung eines Maschinen- oder Anlagenteils, wie beispielsweise in einer Produktionsanlage, bereits bei der ersten Inbetriebnahme des Steuerungsprogramms mit vorgesehen werden. Soll eine Erweiterung dann in die Produktionsanlage integriert werden, so muss nur noch der entsprechende Steuerungsteil im Steuerungsprogramm zur Nutzung freigegeben werden und die Platzhaltermodule gegen die hierfür vorgesehenen funktionsbefähigten E/A-Module getauscht werden.

Eine Erweiterung der Lösung besteht darin, dass die Firmware so gestaltet wird, dass die Betriebsart mit Bestätigung des Vollausbaus der Ein/Ausgabe-Station über einen in der Firmware angelegten Parameter, der von einer Projektierungssoftware, die auf einem Projektierungscomputer läuft, fernbedient gesetzt oder entfernt werden kann, ein- und ausschaltbar ist. Mit dieser Form der Firmware-Gestaltung wird Abwärtskompatibilität erreicht, so dass diese Firmware auch das Verhalten der früheren Firmware annehmen kann, wenn die zusätzliche Betriebsart durch entsprechendes Setzen des Parameters abgeschaltet wird.

Es ist weiterhin vorteilhaft, wenn in einem Kommunikationszyklus mit der Steuerungs-Station Dummy-Daten für das wenigstens eine Platzhaltermodul einfügt werden oder Dummy-Daten für das wenigstens eine Platzhaltermodul von der Steuerungs-Station empfangen werden. Dies hat den Vorteil, dass die Busfunktionalität der Vollausbaustufe in der Form simuliert wird und es bei Ersetzung eines Platzhaltermoduls nicht zur Veränderung der Buszykluszeiten auf dem Feldbus kommt. Bei dem intelligenten Platzhaltermodul würde sogar die Zykluszeit des Systembusses konstant bleiben, da das Platzhaltermodul die Prozessdatenbreite des Moduls aufweist, welches ansonsten auf dem jeweiligen Steckplatz vorgesehen ist.

Eine andere vorteilhafte Maßnahme besteht darin, dass ein Platzhaltermodul einen vorkonfigurierten Speicher aufweist, in dem eine Default-Konfiguration mit einer Voreinstellung für das Platzhaltermodul abgespeichert ist.

Für die interne Kommunikation in der Ein/Ausgabe-Station ist es vorteilhaft, wenn die Firmware des Feldbus-Kopplers in der Betriebsart mit Bestätigung des Vollausbaus mit den Ein/Ausgabe-Modulen der Ein/Ausgabe-Station über den Systembus mit einer reduzierten Prozessdatenbreite kommuniziert, bei der die Reduktion der Prozessdatenbreite der Anzahl der Daten, die pro Kommunikationszyklus für die nicht belegten Ein/Ausgabe-Module eingeplant sind, entspricht. Der Feldbus-Koppler kommuniziert mit den Ein/Ausgabe-Modulen über den Systembus der Ein/Ausgabe-Station mit reduzierter Prozessdatenbreite, da es gilt, dass die Prozessdatenbreite der Ist-Konfiguration < Prozessdatenbreite der Soll-Konfiguration ist. Dies gilt bei einem unbelegten Steckplatz oder einem Steckplatz, in den ein Platzhaltermodul mit Prozessdatenbreite = 0 gesteckt ist.

In einer anderen Variante, bei der die Firmware des Feldbus-Kopplers in der Betriebsart mit Bestätigung des Vollausbaus mit den Ein/Ausgabe-Modulen der Ein/Ausgabe-Station über den Systembus in voller Prozessdatenbreite kommuniziert, ist es erforderlich, das sogenannte intelligente Platzhaltermodule an die Leerplätze eingesteckt werden. Für solch ein Platzhaltermodul ist es vorteilhaft, dass das intelligente Platzhaltermodul so ausgelegt ist, dass es pro internem Kommunikationszyklus simulierte Prozessdaten über den Systembus an den Feldbus-Koppler überträgt und simulierte Prozessdaten von dem Feldbus-Koppler empfängt. Dies hat den großen Vorteil, dass das Timing auf dem Systembus schon bei der geplanten Erstinstallation ohne Vollbelegung der Ein/Ausgabe-Station dem Timing des Vollausbaus der Ein/Ausgabe-Station entspricht.

In einer anderen Variante ist es vorteilhaft, dass die Firmware des Feldbus-Kopplers so ausgelegt ist, dass sie in einem Kommunikationszyklus zum Austausch von Daten mit der Steuerungs-Station Dummy-Daten für das wenigstens eine eingesteckte Platzhaltermodul einfügt und/oder Dummy-Daten für das wenigstens eine Platzhaltermodul (37-39) von der Steuerungs-Station (100) empfängt. Dies hat ebenfalls Timing-Vorteile. In dem Fall geht es allerdings um das Timing auf dem Feldbus bei der Kommunikation mit der Steuerungs-Station, die z.B. als SPS (speicherprogrammierbare Steuerung) realisiert sein kann. Das Feldbus-Timing bleibt dann schon bei der geplanten Erstinstallation ohne Vollbelegung der Ein/Ausgabe-Station gewahrt und ändert sich nicht mehr durch den späteren Vollausbau.

Bei einer besonders einfachen Variante empfängt der Feldbus-Koppler für ein projektiertes Analog-Ausgabemodul, das aber durch ein Platzhaltermodul ersetzt ist, als Dummy-Daten Nullen für das entsprechende Platzhaltermodul von der Steuerungs-Station und leitet diese aber nicht an das Platzhaltermodul über den Systembus der Ein/Ausgabe-Station weiter. Das Gleiche kann auch gemacht werden für einen Leerplatz in der Ein/Ausgabe-Station, wenn kein Platzhaltermodul gesteckt ist.

Genauso ist es vorteilhaft, dass der Feldbus-Koppler für ein projektiertes Analog-Eingabemodul, das durch ein Platzhaltermodul ersetzt ist, als Dummy-Daten Nullen für das Platzhaltermodul an die Steuerungs-Station sendet. So bleibt die Busfunktionalität erhalten und ändert sich nicht bei Ersetzung des Platzhaltermoduls durch ein funktionsfähiges Ein/Ausgabe-Modul. Das Gleiche kann auch gemacht werden für einen Leerplatz in der Ein/Ausgabe-Station, wenn kein Platzhaltermodul gesteckt ist.

Die entsprechenden vorteilhaften Maßnahmen können für entsprechend ausgelegte Feldbus-Koppler erreicht werden. In einer ersten Ausführungsform besteht die Erfindung in einem Feldbus-Koppler, der eine Firmware beinhaltet, die für einen Vollausbau der Ein/Ausgabe-Station ausgelegt ist, wobei die Firmware für die Kommunikation mit einer Steuerungs-Station so ausgelegt ist, dass sie von der Steuerungs-Station als projektierte Soll-Konfiguration den Vollausbau der Ein/Ausgabe-Station empfängt, und dass die Firmware in einer Betriebsart unabhängig von der tatsächlich vorliegenden Belegung der Ein/Ausgabe-Station mit Ein/Ausgabe-Modulen der Steuerungs-Station den Vollausbau der Ein/Ausgabe-Station bestätigt.

Eine weitere Ausführung der Erfindung besteht in einem Platzhaltermodul für eine Ein/Ausgabe-Station, das sich dadurch auszeichnet, dass das wenigstens eine eingesteckte Platzhaltermodul wenigstens einen nichtflüchtigen Speicher und optional einen Mikrocontroller aufweist, und dafür gesorgt wird, dass entweder der Speicher oder der Mikrocontroller ausgelegt ist, die simulierten Prozessdaten über den Systembus an den Feldbus-Koppler zu senden und simulierte Prozessdaten von dem Feldbus-Koppler zu empfangen.

Mehrere Ausführungsbeispiele der Erfindung werden nachfolgend anhand der in den Zeichnungen dargestellten Figuren näher erläutert.

Es zeigen:
- Fig. 1: eine Systemübersicht einer Maschinen- oder Anlagensteuerung mit Feldbussystem nach dem Stand der Technik;
- Fig. 2: eine Ein/Ausgabe-Station eines Feldbussystems nach dem Stand der Technik;
- Fig. 3: ein erstes bevorzugtes Ausführungsbeispiel einer Ein/Ausgabe-Station des Feldbussystems gemäß der Erfindung;
- Fig. 4: ein zweites bevorzugtes Ausführungsbeispiel einer Ein/Ausgabe-Station des Feldbussystems gemäß der Erfindung; und
- Fig. 5: ein Ablaufdiagramm, mit dem das Zusammenspiel der Firmware in dem Feldbus-Koppler (21, 41) mit der Projektierungssoftware verdeutlicht wird.

Die vorliegende Beschreibung veranschaulicht die Prinzipien der erfindungsgemäßen Offenbarung. Es versteht sich somit, dass Fachleute in der Lage sein werden, verschiedene Ausführungen zu konzipieren, die zwar hier nicht explizit beschrieben werden, die aber Prinzipien der erfindungsgemäßen Offenbarung verkörpern und in ihrem Umfang ebenfalls geschützt sein sollen.

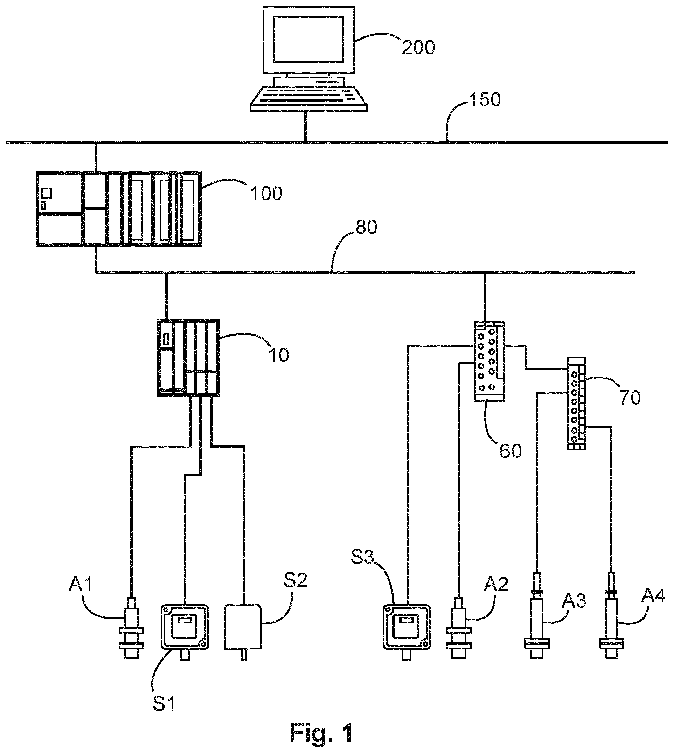

Fig. 1 zeigt eine Systemübersicht für eine Maschinen- oder Anlagensteuerung, die auf dem Einsatz eines Feldbussystems beruht. Der Feldbus ist mit der Bezugszahl 80 bezeichnet. Dieser ist an die Maschinen- oder AnlagenSteuerung 100 angeschlossen. Diese Steuerung 100 wird typischerweise in der Fabrikationshalle aufgestellt. Sie entspricht einem Industrie-PC, der oft als SPS, also als speicherprogrammierbare Steuerung, ausgeführt wird. Die Steuerungsprogramme werden zu der Steuerung 100 über ein weiteres Netzwerk 150 übertragen, das z.B. als Ethernet-Netzwerk, insbesondere Industrial Ethernet-Netzwerk, ausgelegt sein kann. Die Entwicklung der Steuerungsprogramme, die von der Steuerung 100 abgearbeitet werden, findet typischerweise abseits von der Fabrikationshalle in einem Bürokomplex statt. Mit der Bezugszahl 200 ist ein Projektierungs-Computer bezeichnet. Mit diesem Projektierungs-Computer 200 entwickelt der Software-Ingenieur die Steuerungsprogramme. Über das Netzwerk 150 werden die fertigen Steuerungsprogramme an die Steuerung 100 übertragen. Über den Feldbus 80 gelangen die verschiedenen Prozess- oder Anlagendaten zu der Steuerung 100. Umgekehrt werden von der Steuerung 100 die verschiedenen Steuerungsdaten zu den entsprechenden Maschinen- oder Anlagenteilen übertragen. An den Feldbus 80 sind dazu sogenannte Eingabe/Ausgabe-Stationen 10 angeschlossen. Diese sind mit einem Feldbus-Koppler ausgestattet und mit verschiedenen Ein/Ausgabe-Modulen, an die wiederum die verschiedenen Sensoren S1, S2 und Aktoren A1 angeschlossen sind. In Fig. 1 ist weiterhin eine separate Ein/Ausgabe-Einheit 60 dargestellt, die nicht modular aufgebaut ist. An diese ist ein Sensor S3 und ein Aktor A2 angeschlossen. Auch ist daran noch eine Schalteinheit 70 angeschlossen, an die weitere Aktoren A3, A4 angeschlossen sind.

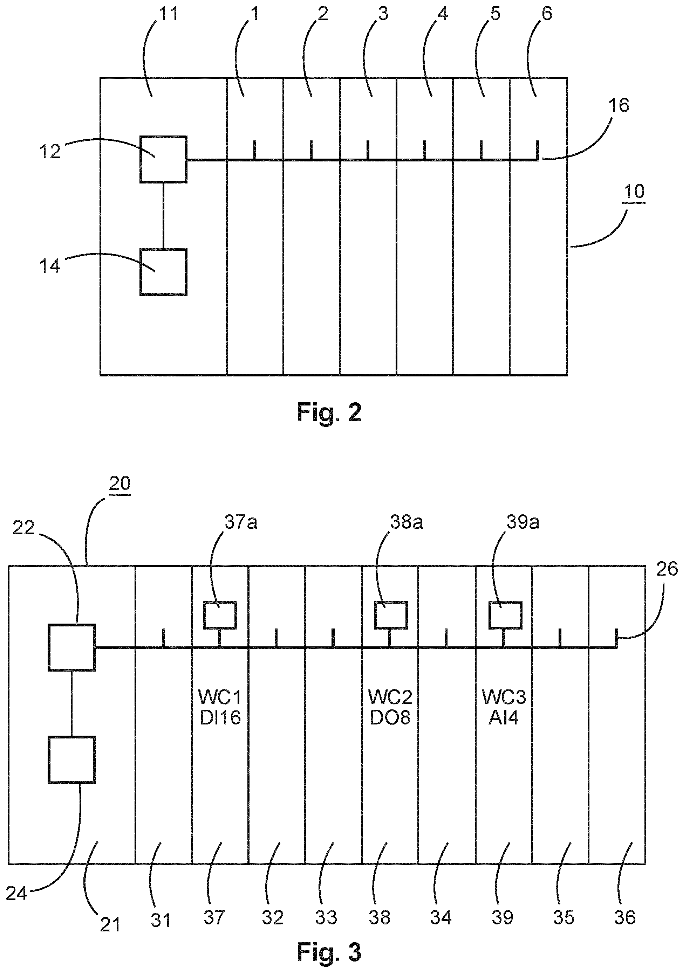

Die Fig. 2 zeigt schematisch die Ein/Ausgabe-Station 10 nach dem Stand der Technik, die in einem Vollausbau sechs steckbare Eingabe- und/oder Ausgabe-Module (E/A-Module) 1-6 aufweist und eine Feldbus-Koppler 11. Der Feldbus-Koppler 11 beinhaltet eine Feldbus-Schnittstelle 14 und eine Systembus-Schnittstelle 12, die an den internen Systembus 16 angeschlossen ist. An den Systembus 16 sind auch die verschiedenen E/A-Module 1-6 angeschlossen.

Jedes der E/A-Module 1-6 bildet hierbei eine Schnittstelle, über die Prozess- oder Maschinen- oder Anlagendaten wie Sensordaten von diesen empfangen werden können und Steuerdaten, an zu kontrollierende Geräte wie Aktoren, gesendet werden können. Die E/A-Module 1-6 weisen jeweils eine eindeutige Adresse auf, über die die E/A-Module 1-6 von der Systembus-Schnittstelle 22 über den Systembus 16 angewählt werden können zum Senden von den Ausgabedaten bzw. Empfangen von den Eingabedaten.

Sollen weitere Funktionen in die Ein/Ausgabe-Station 10 integriert werden, so müssen weitere E/A-Module in das Kommunikationssystem 10 eingesetzt werden, um die neu hinzugekommenen Sensor- und Aktordaten in den Ein/Ausgabezyklus der Ein/Ausgabe-Station 10 einzugliedern. Die neuen E/A-Module enthalten beispielsweise analoge Ein- und Ausgänge oder digitale Ein- und Ausgänge mit entsprechenden Funktionen. Soweit analoge Sensorsignale vorliegen, werden diese digitalisiert und dann in Form digitaler Daten weitergeleitet. Die Hinzufügung zusätzlicher E/A-Module muss dementsprechend auch bei dem Steuerungsprogramm der Steuerungs-Station 100 um diese Funktionalität erweitert werden. Dies ist mit einem erheblichen Aufwand, insbesondere auch Projektierungsaufwand verbunden.

Ein bevorzugtes erstes Ausführungsbeispiel einer erfindungsgemäßen Ein/Ausgabe-Station 20 ist schematisch in der Fig. 3 dargestellt. Die Ein/Ausgabe-Station 20 enthält einen Feldbus-Koppler 21 mit einer Feldbus-Schnittstelle 24 und einer Systembus-Schnittstelle 22 für einen Systembus 26, über die die Feldbus-Schnittstelle 24 mit mehreren E/A-Modulen verbunden ist. In dem Ausführungsbeispiel der Fig. 3 weist die Ein/Ausgabe-Station 20 einen Ausbaugrad mit sechs funktionsbefähigten E/A-Modulen 31-36 und drei funktionslosen Platzhaltermodulen 37-39, in der Fig. 2 als "Wild Card"-Modul (WC1 - WC3) bezeichnet, auf. Jedes der Platzhaltermodule 37-39 weist wenigstens einen vorkonfigurierten Speicher 37a-39a und optional einen Mikrocontroller auf, in denen jeweils eine Default-Konfiguration abgespeichert ist, und jedes der Platzhaltermodule 37-39 ist über den internen Systembus 26 mit der Systembus-Schnittstelle 22 verbunden.

Bei der Projektierung des Steuerprogramms für die Steuerungs-Station 100 wird von vorneherein ein Vollausbau der Ein/Ausgabe-Station 20 mit neun funktionsbefähigten E/A-Modulen 31 - 39 projektiert. Das Steuerprogramm weist dann auch die entsprechenden Programmteile für die funktionsfähigen E/A-Module, die aber noch durch Platzhaltermodule belegt sind, auf.

Die Ein/Ausgabe-Station 20 mit den sechs E/A-Modulen 31-36 ist beispielsweise dazu befähigt, einen Maschinen- oder Anlagenteil zu steuern. Soll dieser Maschinen- oder Anlagenteil zu einem späteren Zeitpunkt erweitert werden, so werden eines, zwei oder alle drei der Platzhaltermodule 37-39 durch funktionsbefähigte E/A-Module, beispielsweise durch die Module DI16, DO8 und AI4, ersetzt. Dabei stehen die Abkürzungen DI für "Digital In", DO für "Digital Out", und AI für "Analog In". Da es sich prinzipiell um die Funktionen des Einlesens von digitalen Daten oder analogen Signalen und der Ausgabe von digitalen Daten handelt, können diese Funktionen mit den entsprechenden Default-Konfigurationen so projektiert werden, dass die Busfunktionalitäten sich durch den Austausch durch funktionsfähige Module nicht verändern. Dies kann insbesondere so realisiert werden, dass der Feldbus-Koppler 21 und der Feldbus-Koppler in der Steuerungs-Station 100 bei den Übertragungszyklen bereits von dem Vollausbau der Ein/Ausgabe-Station 100 ausgehen und simulierte Ein/Ausgabedaten für die Platzhaltermodule 37 - 39 einfügen.

Schon bei der Projektierung mit dem Projektierungs-Computer 200 wird von dem Vollausbau ausgegangen. Das Projektierungsprogramm weist hierbei nur ein Projekt auf und ist daher schon für alle möglichen Ausbauversionen von einer minimalen Ausbauversion mit einem E/A-Modulen bis zu einem Vollausbau mit neun E/A Modulen ausgelegt. Bei einer Inbetriebnahme einer neuen Ausbaustufe ist daher keine Änderung des Projektierungsprogramms notwendig.

Die Platzhaltermodule 37-39 werden mit wenigstens einem vorkonfigurierten Speicher und optional einem Mikrocontroller ausgestattet, wobei beispielsweise bereits bei der Herstellung der Speicher mit einer spezifischen Default-Konfiguration versehen wird. Eine Default-Konfiguration beschreibt hierbei insbesondere die Funktionalität eines E/A-Moduls, das zu einem späteren Zeitpunkt das entsprechende Platzhaltermodul 37, 38 oder 39 ersetzen soll. Das Steuerungsprogramm, das in der Steuerungs-Station 100 für die Ein/AusgabeStation 20 abgearbeitet wird, ist hierbei insbesondere bereits für den Vollausbau mit neun funktionsbefähigten E/A-Modulen ausgelegt, indem das Steuerungsprogramm bereits die Ein/Ausgabe-Funktionalitäten der Module DI16, DO8 und AI4 enthält. Wird später eines oder mehrere der Platzhaltermodule 37-39 durch ein entsprechendes, hierfür vorgesehenes E/A-Modul ersetzt, dann erkennt das Steuerungsprogramm dies daran, dass nun andere Eingabedaten als die simulierten Daten der Default-Konfiguration geliefert werden und nimmt dieses automatisch in Betrieb.

Die Platzhaltermodule 37-39 enthalten insbesondere jeweils die identischen Busfunktionalitäten wie die zu einem späteren Zeitpunkt zu verwendenden funktionsbefähigten E/A-Module, in diesem Ausführungsbeispiel die E/A-Module DI16, DO8 und AI4. Somit kommt es bei einer späteren Aufrüstung durch Hinzufügen von vorgesehenen optionalen Maschinen- oder Anlagenteilen zu keiner Veränderung der Systemlaufzeit, wenn das Steuerungsprogramm über das Kommunikationssystem 20 ausgeführt wird.

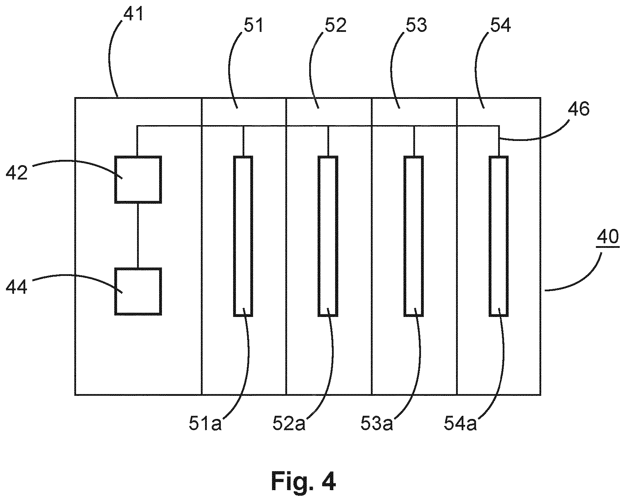

In einem weiteren bevorzugten Ausführungsbeispiel der Erfindung, in der Fig. 4 schematisch dargestellt, enthält eine Ein/Ausgabe-Station 40 eine Systembus-Schnittstelle 42, einen Feldbus-Koppler 44 und ein internes Bussystem 46 (Systembus), sowie vier Steckplätze 51-54 für E/A-Module. Die vier Steckplätze 51-54 weisen jeweils eine Steckverbindung 51a-54a auf, über die ein eingestecktes E/A-Modul mit dem internen Bussystem 46 verbunden ist.

Die Firmware für den Buskoppler 41 ist hier für einen Vollausbau mit vier funktionsbefähigten E/A-Modulen ausgelegt, wobei folgende vier E/A-Module verwendet werden können: Digital-Eingabemodul, Digital-Ausgabemodul, Analog-Eingabemodul oder Analog-Ausgabemodul. Zulässige Ausprägungen für die vier Steckplätze 51-54 sind:
1.) Digital-Eingabemodul, Digital-Ausgabemodul, Analog-Eingabemodul, Analog-Ausgabemodul, entsprechend einem Vollausbau
2.) Digital-Eingabemodul, Digital-Ausgabemodul, Analog-Eingabemodul, Platzhalter-Modul
3.) Digital-Eingabemodul, Digital-Ausgabemodul, Platzhalter-Modul, Analog-Ausgabemodul
4.) Digital-Eingabemodul, Digital-Ausgabemodul, Platzhalter-Modul, Platzhalter-Modul, entsprechend einem minimalen Ausbaugrad.

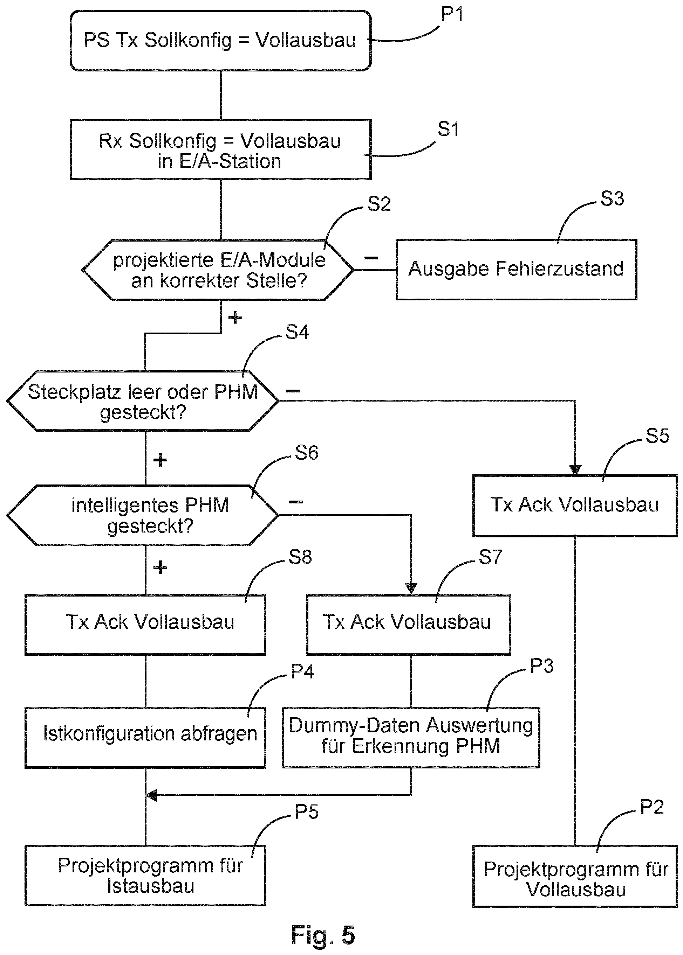

Im Folgenden wird das Verhalten der Firmware des Feldbus-Kopplers mit Hilfe des Ablaufdiagramms in Fig. 5 erläutert. Dabei ist die Firmware gleich für mehrere Varianten ausgelegt. Im Schritt P1 sendet die Projektierungssoftware, die auf dem Projektierungsrechner 200 läuft, eine Sollkonfiguration an die Steuerungs-Station 100 zur Vorbereitung. Diese leitet die Sollvorgabe an die Ein/Ausgabe-Station 20, 40 weiter. Als Sollkonfiguration wird der Ein/AusgabeStation 40 der Vollausbau vorgegeben. Dies erfolgt auch dann, wenn der Maschinen- oder Anlagenbauer eine Ein/Ausgabe-Station 20, 40 in seinem Projekt benutzt, die gar nicht voll belegt ist mit Ein/Ausgabe-Modulen 31-39. Dies hat den Grund, dass nur ein Projekt für alle Ausprägungen durch den Maschinen- oder Anlagenbauer angelegt werden muss und somit der Projektierungs- und Verwaltungsaufwand für den Maschinen- oder Anlagenbauer geringer ist. Im Schritt S1 gelangt die Vorgabe der Sollkonfiguration an den Feldbus-Koppler 21, 41. Die Firmware des Feldbus-Kopplers 21, 41 prüft im Folgenden, ob die vorgegebene Sollkonfiguration überhaupt vorhanden ist in der Ein/Ausgabe-Station 20, 40. Zunächst wird im Schritt S2 geprüft, ob die durch Sollkonfiguration projektierten Ein/Ausgabe-Module 31-39 an der projektierten Stelle in der Ein/Ausgabe-Station 20, 40 gesteckt sind. Dies entspricht einem typischen Vorgang in der Firmware von Bus-Kopplern für Ein/Ausgabe-Stationen 20, 40. Die Prüfung basiert darauf, dass funktionsfähige Ein/Ausgabe-Module 31-36 mit einer Identifikation versehen sind, die in diesem Schritt abgefragt wird. In der Sollkonfiguration sind die Identifikationen der bei Vollausbau gesteckten Ein/Ausgabe-Module 31-39 aufgelistet. Wird bei dieser Prüfung festgestellt, dass ein anderes Ein/Ausgabe-Modul als die projektierten Module gesteckt ist, oder dass ein projektiertes Modul an einem anderen als dem vorgesehenen Steckplatz gesteckt ist, so wird im Schritt S3 eine Fehlermeldung zu der Steuerungs-Station 100 zurückgeliefert. Diese wird dann an den Projektierungsrechner 200 weitergeleitet werden. Gleichzeitig kann vorgesehen sein, dass bei der Ein/Ausgabe-Station 20, 40 eine Fehlerlampe zum Leuchten gebracht wird. Wenn die Ein/Ausgabe-Station 40 mit einer alphanumerischen/grafischen Anzeigeeinheit ausgestattet ist, kann die Fehlermeldung dort auch in Textform ausgegeben werden.

Wenn keine Fehlbelegung erkannt wurde, wird im Schritt S4 geprüft, ob in der Ein/Ausgabe-Station 20, 40 ein Platzhaltermodul 37-39 gesteckt ist oder alternativ ein unbelegter Steckplatz vorliegt. Für den zweiten Fall muss allerdings die Ein/Ausgabe-Station 20, 40 so ausgelegt sein, dass der Feldbus-Koppler 21, 41 es erkennt, dass ein Steckplatz 51a - 54a unbelegt ist. Die Erkennung eines leeren Steckplatzes erfolgt zurzeit mit Hilfe der Firmware des Feldbus-Kopplers. Alternativ kann dies durch einfache schaltungstechnische Maßnahmen erzielt werden. Dafür reicht es bereits aus, dass pro Steckplatz ein Kontakt bei Einstecken eines Ein/Ausgabe-Moduls 31-39 geschlossen oder geöffnet wird, wobei diese Kontakte von dem Feldbus-Koppler 21, 41 überwacht werden.

Falls kein leerer Steckplatz oder ein Platzhaltermodul erkannt wurde, geht der Feldbus-Koppler 21, 41 davon aus, dass der Vollausbau vorliegt und die Firmware verzweigt zum Schritt S5, in dem eine Meldung mit einer Bestätigung des Vollausbaus an die Steuerungs-Station 100 zurückgesendet wird. Dies wird an den Projektierungsrechner 200 weitergeleitet, der das Projektierungsprogramm mit allen Programmteilen für alle Ein/Ausgabe-Module 31-39 entsprechend des Vollausbaus im Schritt P2 abarbeitet.

Wenn bei der Prüfung im Schritt S4 festgestellt wird, dass ein leerer Steckplatz 51a - 54a oder ein Platzhaltermodul 37 - 39 vorhanden ist, folgt noch eine weitere Prüfung im Schritt S6. Diese Prüfung bezieht sich darauf, dass getestet wird, ob ein intelligentes Platzhaltermodul 37-39 auf einen Steckplatz 51a - 54a gesteckt ist. Erkannt werden kann dies daran, dass die Identifikation des Platzhaltermoduls 37-39 abgefragt wird. In dieser Beziehung reagiert ein intelligentes Platzhaltermodul 37-39 wie ein funktionsfähiges Ein/Ausgabe-Modul 31-39. Wenn kein intelligentes Platzhaltermodul erkannt wurde, wird in Schritt S7 ebenfalls die Meldung mit einer Bestätigung des Vollausbaus an die Steuerungs-Station 100 zurückgesendet. Wenn nun ein intelligentes Platzhaltermodul erkannt wurde, wird im Schritt S8 ebenfalls die Meldung mit einer Bestätigung des Vollausbaus an die Steuerungs-Station 100 zurückgesendet. Die Firmware des Feldbus-Kopplers 21, 41 beginnt dann in beiden Fällen, also nach Schritt S7 und S8, mit der Einfügung von Dummy-Daten in den Kommunikationszyklus für die Kommunikation mit der Steuerungs-Station. Für den Fall, dass kein intelligentes Platzhaltermodul 37-39 eingesteckt ist, also nach Schritt S8, können in einer Variante fixe Daten wie Nullen als Prozessdaten eingefügt werden. In einer anderen verbesserten Variante, die bei intelligenten Platzhaltermodulen möglich ist, werden codierte Dummy-Daten eingefügt. An diesen lässt sich z.B. der Typ des intelligenten Platzhaltermoduls 37-39 in der Projektierungssoftware erkennen.

Die Schritte S1 bis S8 zeigen das Verhalten der Firmware auf Seiten des Feldbus-Kopplers 21, 41. Auf Seiten der Projektierungssoftware, die auf dem Projektierungscomputer 200 läuft, folgen noch Schritte, die ebenfalls in Fig. 5 gezeigt sind. Im Schritt P3 wird überprüft, ob codierte Dummy-Daten in dem Kommunikationszyklus für die Kommunikation mit der Steuerungs-Station 100 eingetragen sind. Falls ja, werden diese in dem Schritt P3 ausgewertet. So kann die Projektierungssoftware intelligente Platzhaltermodule 37-39 erkennen, ohne selbst eine Anfrage an die Ein/Ausgabe-Station 20, 40 zu senden. Wenn auf diese Weise die Information über die gesteckten Platzhaltermodule 37-39 gewonnen werden konnte, kann die Projektierungssoftware selbst entscheiden, welche Programmteile für die nicht gesteckten Ein/Ausgabe-Module ausgelassen werden müssen. Wenn kein intelligentes Platzhaltermodul gesteckt ist, wird diese Information im Schritt P4 dadurch gewonnen, dass eine konventionelle Abfrage der Istkonfiguration an die Ein/Ausgabe-Station 20, 40 gesendet wird. Mit Eingang des Berichts über die Istkonfiguration können auch die entsprechenden Programmteile für die nicht mit funktionsfähigen Ein/Ausgabe-Modulen 31-39 belegten Steckplätze unterdrückt werden.

Die Platzhaltermodule für die Ein/Ausgabe-Station 40 besitzen vorzugsweise eine Prozessdatenbreite von Null Byte. Weist die Ein/Ausgabe-Station 40 beispielsweise die Ausprägung 4.) mit zwei Platzhaltermodulen auf, so kommuniziert die Systembus-Schnittstelle 42 während der Ausführung des Steuerungsprogramms in der Steuerungs-Station 100 mit den vorhanden E/A-Modulen mit reduzierter Prozessdatenbreite, da die Prozessdatenbreite der Ist-Konfiguration kleiner als die Prozessdatenbreite des Vollausbaus ist.

Für das projektierte Analog-Ausgabemodul, in dessen Steckplatz noch eines der Platzhaltermodule steckt, werden Dummy-Daten an den Feldbus-Koppler 41 gesendet. Der Feldbus-Koppler 41 entfernt die Prozessdaten für das Analog-Ausgabemodul, da dies nicht hinter dem Feldbus-Koppler 41 verbaut oder gesteckt ist, sondern stattdessen das Platzhalter-Modul mit Prozessdatenbreite Null. Für das projektierte aber nicht verbaute bzw. nicht gesteckte Analog-Eingabemodul sendet der Feldbus-Koppler 41 Dummy-Daten an die Steuerungs-Station 100; da der Programmteil für das Analog-Eingabemodul dort aber nicht durchlaufen wird, werden die Dummy-Daten erkannt und gar nicht erst an den Programmteil für dieses E/A-Modul weitergeleitet. Es kann sehr variabel festgelegt werden, welche Dummy-Daten hierfür verwendet werden. Im einfachsten Fall können "Nullen" als Dummy-Daten gesendet werden.

Bei Ein/Ausgabe-Stationen mit der Schutzart IP20, bei denen die E/A-Module in Steckplätze eines Grundträgers gesteckt werden, müssen unbenutzte Steckplätze zum Schutz gegen ESD, Staub etc. mit einer entsprechenden Abdeckung versehen werden. Wenn ein Platzhaltermodul gesteckt ist, ist dieser Schutz gegeben. Bei offenliegenden Leerplätzen allerdings nicht. Um das zu vermeiden, kann eine Steckplatzabdeckung eingesetzt werden. Das Fehlen einer solchen Abdeckung bleibt unter Umständen unbemerkt und kann im Betrieb der Ein/Ausgabe-Station zum Fehlverhalten oder Ausfall der Ein/Ausgabe-Station führen, was wiederum den Stillstand der Maschine oder Anlage zur Folge haben kann. Hier ist es erforderlich, eine Lösung zu finden, mit der das Fehlen dieser Abdeckung automatisch erkannt und angezeigt wird.

Eine Lösung beruht darauf, dass die Abdeckung eine Elektronik beinhaltet, anhand der die Abdeckung als solche identifizierbar ist. Ein Ausführungsbeispiel dieser Lösung besteht in einer Ein/Ausgabe-Station 10 bestehend aus einem Feldbuskoppler 21, 41 und einem Grundträger mit einer Anzahl Steckplätzen 51a bis 54a für E/A-Module 31 bis 39. Die Steckplatzabdeckung wird wie das Platzhaltermodul mit Prozessdatenbreite Null mit einem nichtflüchtigen Speicher bestückt, welcher z.B. als ein EEPROM ausgebildet ist. In einer Projektierungs- bzw. Engineering-Software ist diese Konfiguration unter Verwendung der entsprechenden Gerätebeschreibungsdateien (z.B. GSDML für Profinet) projektiert. Auch für diese Art der Steckplatzabdeckung existiert eine entsprechende Gerätebeschreibungsdatei. Beim Fehlen der Abdeckung wird in der Projektierungs bzw. Engineering-Software eine entsprechende Fehlermeldung oder ein entsprechender (Warn-)Hinweis angezeigt.

Das EEPROM kann dafür mit einem eindeutigen Objekt mit ID Code, z.B. Device-Type-Code, programmiert sein. Dieser einprogrammierte Device-Type-Code kann von dem Feldbus-Koppler 21, 41 der Ein/Ausgabe-Station 10 ausgewertet werden. Bei fehlendem EEPORM bzw. bei Fehlen des Objektes mit Device-Typ-Code wird eine Warnung z.B. "Steckplatz nicht abgedeckt" bzw. "ESD-Schutz nicht gesteckt - Backplane x Slot y" inklusive Angabe des betroffenen Steckplatzes (inkl. Ortung z.B. Backplane 3 Slot 5) abgesetzt.

Es sollte verstanden werden, dass das vorgeschlagene Kommunikationssystem in verschiedenen Formen von Hardware, Software, Firmware und mit Spezialprozessoren oder einer Kombination davon implementiert werden kann. In einer bevorzugten Variante werden Mikrocontroller mit integriertem RAM-Speicher und entsprechenden I/O-Schnittstellen für die Prozessoren 22 und 42 eingesetzt. Für die Speicher 37a-39a werden insbesondere nichtflüchtige, programmierbare Speicher verwendet. Die Speicher 24 und 44 können flüchtig oder nichtflüchtig aufgebaut sein und bereits im Prozessor 22 bzw. 42 integriert sein. Die Prozessoren 22 und 42 können insbesondere auch anwendungsspezifische integrierte Schaltungen (ASICs), Reduced Instruction Set Computer (RISC) und/oder Field Programmable Gate Arrays (FPGAs) umfassen. Vorzugsweise wird das vorgeschlagene Kommunikationssystem als eine Kombination von Hardware und Software implementiert. Die Software wird vorzugsweise als ein Betriebsprogramm auf einem oder mehreren nichtflüchtigen Speichern innerhalb des Kommunikationssystems 20 bzw. 40 installiert.

Die Offenbarung ist nicht auf die hier beschriebenen Ausführungsbeispiele beschränkt. Es gibt Raum für verschiedene Anpassungen und Modifikationen, die der Fachmann aufgrund seines Fachwissens als auch zu der Offenbarung zugehörend in Betracht ziehen würde.

**Bezugszeichenliste**

| | |
|---|---|
| Steckbare Ein/Ausgabe-Module | 1-6 |
| Erste Ein/Ausgabe-Station | 10 |
| Erster Feldbus-Koppler | 11 |
| Erste Systembus-Schnittstelle | 12 |
| Erste Feldbus-Schnittstelle | 14 |
| Erster Systembus | 16 |
| | |
| Zweite Ein/Ausgabe-Station | 20 |
| Zweite Systembus-Schnittstelle | 22 |
| Zweiter Feldbus-Koppler | 21 |
| Zweite Feldbus-Schnittstelle | 24 |
| Zweiter Systembus | 26 |
| Zweite steckbare Ein/Ausgabe-Module | 31 - 36 |
| Platzhaltermodule | 37 - 39 |
| | |
| Dritte Ein/Ausgabe-Station | 40 |
| Dritte Systembus-Schnittstelle | 42 |
| Dritter Feldbus-Koppler | 41 |
| Dritte Feldbus-Schnittstelle | 44 |
| Dritter Systembus | 46 |
| Steckplätze | 51 - 54 |
| Steckverbindungen | 51a - 54a |
| Ein/Ausgabe-Einheit | 60 |
| Schalteinheit | 70 |
| Feldbus | 80 |
| Steuerungs-Station | 100 |
| Netzwerk | 150 |
| Projektierungscomputer | 200 |
| | |
| 1. Sensor | S1 |
| 2. Sensor | S2 |
| 3. Sensor | S3 |
| 1. Aktor | A1 |
| 2. Aktor | A2 |
| 3. Aktor | A3 |
| 4. Aktor | A4 |
| Verschiedene Schritte im Projektierungsprogramm | P1 - P5 |
| Verschiedene Schritte der Feldbus-Koppler Firmware | S1 - S8 |

## Patentansprüche

1. Ein/Ausgabe-Station (20; 40) für ein Feldbussystem mit einem Feldbus-Koppler (21, 41), der eine Systembus-Schnittstelle (22; 42) zu einem Systembus (26, 46) und eine Feldbus-Schnittstelle (24; 44) aufweist, wobei die Ein/Ausgabe-Station (20, 40) eine Anzahl Steckplätze (51a-54a) zum Systembus (26, 46) für steckbare Ein/Ausgabe-Module (31-36) aufweist, in die neben einer Anzahl von Ein/Ausgabe-Modulen (31-36) auch ein oder mehr Platzhaltermodule (37-39) einsteckbar sind, wobei auch ein leerer Steckplatz eine zulässige Variante darstellt, wobei der Feldbus-Koppler (21, 41) eine Firmware beinhaltet, die für einen Vollausbau der Ein/AusgabeStation (20, 40) ausgelegt ist, wobei die Firmware für die Kommunikation mit einer Steuerungs-Station (100) so ausgelegt ist, dass sie von der Steuerungs-Station (100) als projektierte Soll-Konfiguration den Vollausbau der Ein/Ausgabe-Station (20; 40) empfängt, **dadurch gekennzeichnet, dass** die Firmware in einer Betriebsart unabhängig von der tatsächlich vorliegenden Belegung der Ein/Ausgabe-Station (20, 40) mit Ein/Ausgabe-Modulen der Steuerungs-Station (100) den Vollausbau der Ein/Ausgabe-Station (20; 40) bestätigt.

2. Ein/Ausgabe-Station (20; 40) nach Anspruch 1, wobei die Firmware so ausgelegt ist, dass die Betriebsart mit Bestätigung des Vollausbaus der Ein/Ausgabe-Station (20, 40) über einen in der Firmware angelegten Parameter, der von einer Projektierungssoftware, die auf einem Projektierungscomputer (200) läuft, fernbedient gesetzt oder entfernt werden kann, ein- und ausschaltbar ist.

3. Ein/Ausgabe-Station (20; 40) nach Anspruch 1 oder 2, wobei die Firmware des Feldbus-Kopplers (21, 41) in der Betriebsart mit Bestätigung des Vollausbaus mit den Ein/Ausgabe-Modulen (31-36) der Ein/Ausgabe-Station (20, 40) über den Systembus (26, 46) mit einer reduzierten Prozessdatenbreite kommuniziert, bei der die Reduktion der Prozessdatenbreite der Anzahl der Daten, die pro Kommunikationszyklus für die nicht belegten Ein/Ausgabe-Module (31-36) eingeplant sind, entspricht.

4. Ein/Ausgabe-Station (20; 40) nach Anspruch 1 oder 2, wobei die Firmware des Feldbus-Kopplers (21, 41) in der Betriebsart mit Bestätigung des Vollausbaus mit den Ein/Ausgabe-Modulen (31-36) der Ein/Ausgabe-Station (20, 40) über den Systembus (26, 46) in voller Prozessdatenbreite kommuniziert, wobei wenigstens ein eingestecktes Platzhaltermodul (37-39) des einen oder der mehreren Platzhaltermodule (37-39) so ausgelegt ist, dass es pro internem Kommunikationszyklus simulierte Prozessdaten über den Systembus (26, 46) an den Feldbus-Koppler (21, 41) überträgt und simulierte Prozessdaten von dem Feldbus-Koppler (21, 41) empfängt.

5. Ein/Ausgabe-Station (20; 40) nach Anspruch 4, wobei die Firmware des Feldbus-Kopplers (21, 41) so ausgelegt ist, dass sie in einem Kommunikationszyklus mit der Steuerungs-Station (100) die Dummy-Daten für das wenigstens eine eingesteckte Platzhaltermodul (37-39) des einen oder der mehreren Platzhaltermodule (37-39) einfügt und/oder Dummy-Daten für das wenigstens eine Platzhaltermodul (37-39) des einen oder der mehreren Platzhaltermodule (37-39) von der Steuerungs-Station (100) empfängt.

6. Ein/Ausgabe-Station (20; 40) nach Anspruch 5, wobei die Firmware so ausgelegt ist, dass sie als Dummy-Daten einen Platzhaltermodul-Typcode für das wenigstens eine eingesteckte Platzhaltermodul (37-39) des einen oder der mehreren Platzhaltermodule (37-39) in dem Kommunikationszyklus mit der Steuerungs-Station (100) einfügt.

7. Ein/Ausgabe-Station (20; 40) nach Anspruch 4 oder 5, wobei die Firmware des Feldbus-Kopplers (21, 41) so ausgelegt ist, dass sie für ein projektiertes Analog-Ausgabemodul, das durch ein Platzhaltermodul (37-39) ersetzt ist, Dummy-Daten für das entsprechende Platzhaltermodul (37-39) von der Steuerungs-Station (100) empfängt, diese aber über den Systembus (26, 46) nicht an das Platzhaltermodul (37-39) weiterleitet.

8. Ein/Ausgabe-Station (20; 40) nach einem der Ansprüche 4, 5 oder 7, wobei die Firmware des Feldbus-Kopplers (21, 41) für ein projektiertes Analog-Eingabemodul, das durch ein Platzhaltermodul (37-39) ersetzt ist, Dummy-Daten für das Platzhaltermodul (37-39) an die Steuerungs-Station (100) sendet.

9. Ein/Ausgabe-Station (20; 40) nach einem der Ansprüche 4 bis 6, wobei das wenigstens eine eingesteckte Platzhaltermodul (37-39) wenigstens einen nichtflüchtigen Speicher und optional einen Mikrocontroller aufweist, und die ausgelegt sind simulierte Prozessdaten über den Systembus (26, 46) an den Feldbus-Koppler (21, 41) zu senden und simulierte Prozessdaten von dem Feldbus-Koppler (21, 41) zu empfangen.

10. Feldbus-Koppler (21, 41) für eine Ein/Ausgabe-Station (20, 40) nach einem der vorangehenden Ansprüche, **dadurch gekennzeichnet, dass** der Feldbus-Koppler (21, 41) mit einer Firmware nach einem der vorhergehenden Ansprüche ausgestattet ist.

11. Platzhaltermodul (37-39) für eine Ein/Ausgabe-Station (20, 40) nach einem der vorangehenden Ansprüche, **dadurch gekennzeichnet, dass** das Platzhaltermodul (37-39) wenigstens einen nichtflüchtigen Speicher und optional einen Mikrocontroller aufweist, die ausgelegt sind, simulierte Prozessdaten über den Systembus (26, 46) an den Feldbus-Koppler (21, 41) zu senden und simulierte Prozessdaten von dem Feldbus-Koppler (21, 41) zu empfangen.

## Claims

1. An input/output, I/O, station (20; 40) for a fieldbus system with a fieldbus coupler (21, 41), which has a system bus interface (22; 42) to a system bus (26, 46) and a fieldbus interface (24; 44), wherein the I/O station (20, 40) has a number of slots (51a-54a) to the system bus (26, 46) for pluggable I/O modules (31-36), into which, besides a number of I/O modules (31-36), also one or more placeholder modules (37-39) can be plugged, wherein an empty slot also represents a permissible variant, wherein the fieldbus coupler (21, 41) includes firmware that is designed for a full expansion of the I/O station (20, 40), wherein the firmware for communication with a control station (100) is designed such that it receives from the control station (100), as a projected target configuration, the full expansion of the I/O station (20; 40), **characterized in that**, in an operating mode, the firmware confirms to the control station (100) the full expansion of the I/O station (20; 40) irrespective of the actually present occupancy of the I/O station (20, 40) with I/O modules.

2. The I/O station (20; 40) according to claim 1, wherein the firmware is designed such that the operating mode with confirmation of the full expansion of the I/O station (20, 40) can be switched on and off via a parameter stored in the firmware, which can be remotely set or removed by an engineering software running on an engineering computer (200).

3. The I/O station (20; 40) according to claim 1 or 2, wherein the firmware of the fieldbus coupler (21, 41), in the operating mode with confirmation of the full expansion, communicates with the I/O modules (31-36) of the I/O station (20, 40) via the system bus (26, 46) with a reduced process data width, wherein the reduction of the process data width corresponds to the number of data that are planned per communication cycle for the unoccupied I/O modules (31-36).

4. The I/O station (20; 40) according to claim 1 or 2, wherein the firmware of the fieldbus coupler (21, 41), in the operating mode with confirmation of the full expansion, communicates with the I/O modules (31-36) of the I/O station (20, 40) via the system bus (26, 46) in full process data width, wherein at least one plugged-in placeholder module (37-39) of the one or the several placeholder modules (37-39) is designed such that it transmits simulated process data via the system bus (26, 46) to the fieldbus coupler (21, 41) per internal communication cycle and receives simulated process data from the fieldbus coupler (21, 41).

5. The I/O station (20; 40) according to claim 4, wherein the firmware of the fieldbus coupler (21, 41) is designed such that, in a communication cycle with the control station (100), it inserts the dummy data for the at least one plugged-in placeholder module (37-39) of the one or the several placeholder modules (37-39) and/or receives dummy data for the at least one placeholder module (37-39) of the one or the several placeholder modules (37-39) from the control station (100).

6. The I/O station (20; 40) according to claim 5, wherein the firmware is designed such that, as dummy data, it inserts a placeholder module type code for the at least one plugged-in placeholder module (37-39) of the one or the several placeholder modules (37-39) in the communication cycle with the control station (100).

7. The I/O station (20; 40) according to claim 4 or 5, wherein the firmware of the fieldbus coupler (21, 41) is designed such that, for a projected analog output module that is replaced by a placeholder module (37-39), it receives dummy data for the corresponding placeholder module (37-39) from the control station (100), but does not forward these via the system bus (26, 46) to the placeholder module (37-39).

8. The I/O station (20; 40) according to one of claims 4, 5 or 7, wherein the firmware of the fieldbus coupler (21, 41), for a projected analog input module that is replaced by a placeholder module (37-39), sends dummy data for the placeholder module (37-39) to the control station (100).

9. The I/O station (20; 40) according to one of claims 4 to 6, wherein the at least one plugged-in placeholder module (37-39) has at least one non-volatile memory and optionally a microcontroller, and which are designed to send simulated process data via the system bus (26, 46) to the fieldbus coupler (21, 41) and to receive simulated process data from the fieldbus coupler (21, 41).

10. A fieldbus coupler (21, 41) for an I/O station (20, 40) according to one of the preceding claims, **characterized in that** the fieldbus coupler (21, 41) is equipped with firmware according to one of the preceding claims.

11. A placeholder module (37-39) for an I/O station (20, 40) according to one of the preceding claims, **characterized in that** the placeholder module (37-39) has at least one non-volatile memory and optionally a microcontroller, which are designed to send simulated process data via the system bus (26, 46) to the fieldbus coupler (21, 41) and to receive simulated process data from the fieldbus coupler (21, 41).

## Revendications

1. Une station d'entrées/sorties (20; 40) pour un système de bus de terrain avec un coupleur de bus de terrain (21, 41) qui présente une interface de bus système (22; 42) vers un bus système (26, 46) et une interface de bus de terrain (24; 44), dans laquelle la station d'entrées/sorties (20, 40) présente un nombre d'emplacements enfichables (51a-54a) vers le bus système (26, 46) pour des modules d'entrées/sorties enfichables (31-36), dans lesquels, outre un nombre de modules d'entrées/sorties (31-36), un ou plusieurs modules espace réservé (37-39) peuvent également être enfichés, dans laquelle un emplacement enfichable vide représente également une variante admissible, dans laquelle le coupleur de bus de terrain (21, 41) comprend un firmware qui est conçu pour un équipement complet de la station d'entrées/sorties (20, 40), dans laquelle le firmware est conçu pour la communication avec une station de commande (100) de sorte qu'il reçoit de la station de commande (100), en tant que configuration cible projetée, l'équipement complet de la station d'entrées/sorties (20; 40), **caractérisée en ce que** le firmware, dans un mode de fonctionnement, indépendamment de l'occupation réellement présente de la station d'entrées/sorties (20, 40) avec des modules d'entrées/sorties, confirme à la station de commande (100) l'équipement complet de la station d'entrées/sorties (20; 40).

2. Station d'entrées/sorties (20; 40) selon la revendication 1, dans laquelle le firmware est conçu de sorte que le mode de fonctionnement avec confirmation de l'équipement complet de la station d'entrées/sorties (20, 40) puisse être activé et désactivé au moyen d'un paramètre enregistré dans le firmware, lequel paramètre peut être réglé ou supprimé à distance par un logiciel de configuration qui s'exécute sur un ordinateur de configuration (200).

3. Station d'entrées/sorties (20; 40) selon la revendication 1 ou 2, dans laquelle le firmware du coupleur de bus de terrain (21, 41), dans le mode de fonctionnement avec confirmation de l'équipement complet, communique avec les modules d'entrées/sorties (31-36) de la station d'entrées/sorties (20, 40) via le bus système (26, 46) avec une largeur de données de processus réduite, dans laquelle la réduction de la largeur de données de processus correspond au nombre de données qui sont planifiées par cycle de communication pour les modules d'entrées/sorties (31-36) non occupés.

4. Station d'entrées/sorties (20; 40) selon la revendication 1 ou 2, dans laquelle le firmware du coupleur de bus de terrain (21, 41), dans le mode de fonctionnement avec confirmation de l'équipement complet, communique avec les modules d'entrées/sorties (31-36) de la station d'entrées/sorties (20, 40) via le bus système (26, 46) en pleine largeur de données de processus, dans laquelle au moins un module espace réservé enfiché (37-39) du ou des modules espace réservé (37-39) est conçu de sorte qu'il transmet, par cycle de communication interne, des données de processus simulées via le bus système (26, 46) au coupleur de bus de terrain (21, 41) et reçoit des données de processus simulées du coupleur de bus de terrain (21, 41).

5. Station d'entrées/sorties (20; 40) selon la revendication 4, dans laquelle le firmware du coupleur de bus de terrain (21, 41) est conçu de sorte que, dans un cycle de communication avec la station de commande (100), il insère les données fictives pour le au moins un module espace réservé enfiché (37-39) du ou des modules espace réservé (37-39) et/ou reçoit des données fictives pour le au moins un module espace réservé (37-39) du ou des modules espace réservé (37-39) de la station de commande (100).

6. Station d'entrées/sorties (20; 40) selon la revendication 5, dans laquelle le firmware est conçu de sorte que, en tant que données fictives, il insère un code de type de module espace réservé pour le au moins un module espace réservé enfiché (37-39) du ou des modules espace réservé (37-39) dans le cycle de communication avec la station de commande (100).

7. Station d'entrées/sorties (20; 40) selon la revendication 4 ou 5, dans laquelle le firmware du coupleur de bus de terrain (21, 41) est conçu de sorte que, pour un module de sortie analogique projeté qui est remplacé par un module espace réservé (37-39), il reçoit des données fictives pour le module espace réservé correspondant (37-39) de la station de commande (100), mais ne les transmet pas via le bus système (26, 46) au module espace réservé (37-39).

8. Station d'entrées/sorties (20; 40) selon l'une des revendications 4, 5 ou 7, dans laquelle le firmware du coupleur de bus de terrain (21, 41), pour un module d'entrée analogique projeté qui est remplacé par un module espace réservé (37-39), envoie des données fictives pour le module espace réservé (37-39) à la station de commande (100).

9. Station d'entrées/sorties (20; 40) selon l'une des revendications 4 à 6, dans laquelle le au moins un module espace réservé enfiché (37-39) présente au moins une mémoire non volatile et en option un microcontrôleur, et qui sont conçus pour envoyer des données de processus simulées via le bus système (26, 46) au coupleur de bus de terrain (21, 41) et pour recevoir des données de processus simulées du coupleur de bus de terrain (21, 41).

10. Un coupleur de bus de terrain (21, 41) pour une station d'entrées/sorties (20, 40) selon l'une des revendications précédentes, **caractérisé en ce que** le coupleur de bus de terrain (21, 41) est équipé d'un firmware selon l'une des revendications précédentes.

11. Un module espace réservé (37-39) pour une station d'entrées/sorties (20, 40) selon l'une des revendications précédentes, **caractérisé en ce que** le module espace réservé (37-39) présente au moins une mémoire non volatile et en option un microcontrôleur, qui sont conçus pour envoyer des données de processus simulées via le bus système (26, 46) au coupleur de bus de terrain (21, 41) et pour recevoir des données de processus simulées du coupleur de bus de terrain (21, 41).
